# EUROPEAN PATENT APPLICATION

(11) **EP 1 538 525 A1**
(43) Date of publication of application: **08.06.2005**
(21) Application number: 03293051.3
(22) Date of filing: 04.12.2003
(51) Int. Cl.: G06F 11/10, G11C 16/10

(54) **ECC computation simultaneously performed while reading or programming a flash memory**

(71) Applicant: TEXAS INSTRUMENTS INCORPORATED, Dallas, TX 75265 (US); TEXAS INSTRUMENTS FRANCE, 06271 Villeneuve Loubet Cédex (FR)
(72) Inventor: Simon, Jean-Yves, 06700 St Laurent du Var (FR)
(74) Representative: Holt, Michael

(57) **Abstract**

An apparatus and method for streamlining ECC computation comprising computing ECC concurrently while either reading data from Flash memory, or programming data to or from Flash memory, so that a block of data does not have to be saved in memory before the ECC computation can be started.

## Description

### FIELD OF THE INVENTION

The present invention relates to Error Correction Code (ECC) computation, and, more particularly, to an apparatus and method for streamlining ECC computation.

### BACKGROUND OF THE INVENTION

There is a need to avoid any penalty in performance while computing Error Correction Code (ECC) to detect an error in Flash memory, particularly NAND Flash memory. A conventional approach is to save a full page of NAND Flash in memory and afterwards to compute the ECC.

### SUMMARY OF THE INVENTION

According to a first embodiment of the invention, there is provided a method of streamlining ECC computation comprising: computing ECC concurrently while either reading data from Flash memory or programming data to or from Flash memory, so that a block of data does not have to be saved in memory before the ECC computation can be started. Preferably the block or data is 256 bytes or 512 bytes in size.

In a preferred embodiment, the method further comprises: when the ECC computation for the block of data is completed, saving the ECC for the block of data in a first ECC register; and moving an ECC pointer to the next ECC register so that when the ECC for the next block of data is computed, it is saved immediately. Preferably there are sufficient registers to protect a page of data.

In further preferred embodiment, the block of data is 256 bytes in size, and for a 2 Kbyte page with a spare area of 64 bytes of Flash memory, 9 registers are used.

Advantageously, the invention avoids any penalty in performance and further provides an improvement in performance by conducting ECC computation concurrently with reading or programming a Flash memory. Further advantageously, a full page of Flash memory can be read or program without having to stop and wait for ECC computation. Also advantageously, no time is lost by automatically switching to a next register when one ECC computation on a block of data is complete.

Specific embodiments of the present invention will now be described, by way of example only, with reference to the accompanying drawings, in which:

### BREIF DESCRIPTION OF THE DRAWINGS

Figure 1 is a diagram showing the principle of a NAND Flash Controller with on-board ECC engine in accordance with a preferred embodiment of the invention;
Figure 2a is a block diagram showing the steps involved in streamlining ECC computation while reading data from NAND Flash memory in accordance with a further embodiment of the invention;
Figure 2b is a block diagram showing the steps involved in streamlining ECC computation while programming NAND Flash memory in accordance with a another embodiment of the invention; and
Figure 3 is a diagram showing the calculation of the ECC of a full page while saving the intermediate ECC results in registers with an automatic switching of ECC registers.

### SPECIFIC DESCRIPTION OF EMBODIMENTS OF THE INVENTION

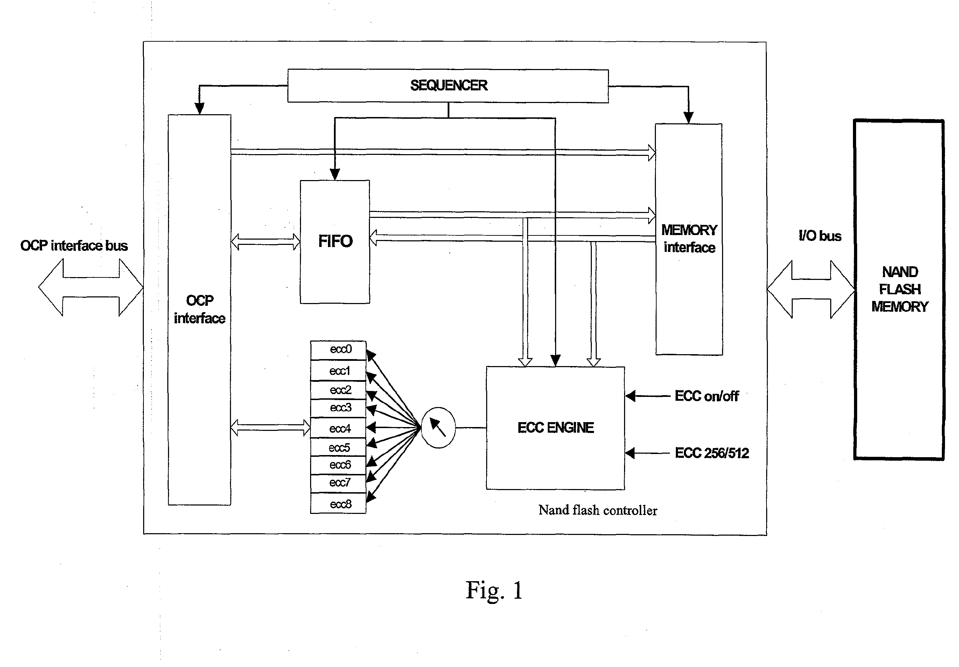

The present invention provides a method and apparatus for streamlining Error Correction Code (ECC) computation by conducting ECC computation concurrently with either a data read from a flash memory or a program to the flash memory. Figure 1 is a diagram showing the principle of a NAND Flash Controller with onboard ECC engine in accordance with a preferred embodiment.

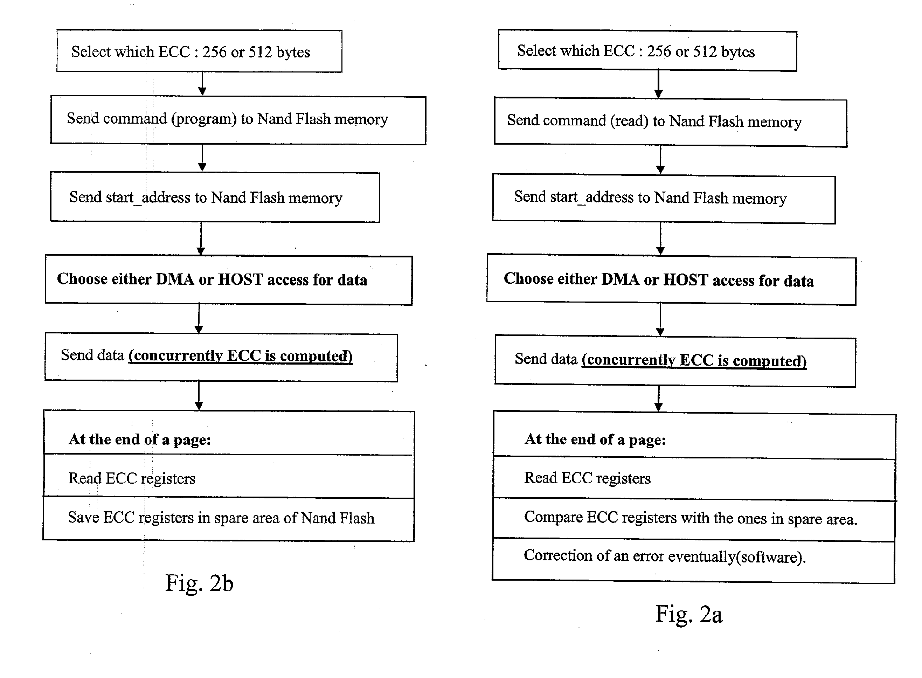

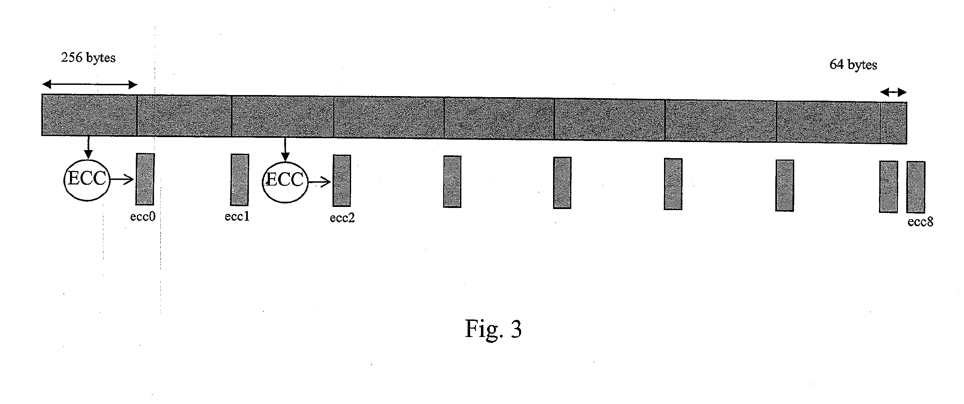

Figures 2a and 2b are block diagrams showing the steps involved in the method of streamlining ECC computation according to the preferred embodiment. With reference to Figure 2a, the steps involved in conducting ECC computation concurrently with a data read will be described. Firstly, the type of ECC is selected: 256 bytes or 512 bytes. Next a data read command is sent to the NAND Flash memory. Then a start_address is sent to the NAND Flash memory, and either DMA or HOST access is chosen for data. Next ECC is computed concurrently with the data being read, as is more fully explained below with reference to Figure 3. At the end of a page, the ECC registers are read and are compared with the ones in the spare area in the NAND Flash memory, and correction of errors are eventually carried out using software.

Figure 2b shows a similar process for conducting ECC computation while programming Flash memory. Firstly, the type of ECC is selected: 256 bytes or 512 bytes. Next a program command is sent to the NAND Flash memory. Then a start_address is sent to the NAND Flash memory, and either DMA or HOST access is chosen for data. Next ECC is computed concurrently with the data being sent, as is more fully explained below with reference to Figure 3. At the end of a page, the ECC registers are read and are saved in the spare area in the NAND Flash memory.

With reference to Figure 3, ECC computation is carried out concurrently with either a data read from the NAND Flash memory or program to the NAND Flash memory, so that a block of 256 or 512 bytes do not have to be saved in memory before the ECC checking can be started. Hence there is no penalty in performance. Secondly, the invention provides an improvement in performance because, as soon as a block of 256 or 512 bytes of data (which is selectable) has its ECC ready, the ECC is saved in the first ECC register and the ECC pointer moves to the next ECC register so that when the next block of data has its ECC ready, it is automatically saved, the ECC pointer moves to next ECC register, and so the process continues. There are enough registers to protect a page. For a 2Kbyte page + spare area (64 bytes) of NAND Flash memory, and for an ECC computation on 256 bytes, 9 registers are necessary.

Advantageously, a full page of NAND Flash memory can be read or program without having to stop and wait for ECC computation. This method is particularly efficient when a DMA engine reads data from Flash memory or programs data to Flash memory, since the host processor does not have to stop every block of 256 or 512 bytes (depending on the chosen ECC) to dump the ECC registers. At the end of a page, the software detects an error by comparaing the calculated ECC to the previous one which was done when a page was programmed. This technique works whatever the data size (8 bits or 16 bits NAND Flash memory). A futher advantage of the technique is that no external memory is needed except the one needed to save the data from the NAND Flash.

## Claims

1. An apparatus or method substantially as hereinbefore described with reference to the any of the accompanying drawings.
